# EUROPEAN PATENT SPECIFICATION

(11) **EP 0 523 770 B1**
(45) Date of publication and mention of the grant of the patent: **29.09.1999**
(21) Application number: 92201921.1
(22) Date of filing: 29.06.1992
(51) Int. Cl.: H01Q 1/24, H01Q 21/00, H03D 9/06

(54) **Low-noise-block downconverter for use with flat antenna receiving dual polarized electromagnetic waves**
Abwärtsumwandlerblock mit geringem Rauschen zur Anwendung in einer ebenen Antenne für doppelt polarisierte elektromagnetische Wellen
Bloc convertisseur à faible bruit utilisé dans une antenne plane recevant des ondes électromagnétiques à double polarisation

(30) Priority: 15.07.1991 JP 17287191; 15.07.1991 JP 17287291; 15.07.1991 JP 17288691; 25.10.1991 JP 27988991; 09.01.1992 JP 226492; 15.04.1992 JP 9466292
(43) Date of publication of application: 20.01.1993
(73) Proprietor: MATSUSHITA ELECTRIC WORKS, LTD., Kadoma-shi Osaka 571 (JP)
(72) Inventor: Kanda, Minoru, Matsushita Elec. Works Ltd., Kadoma-shi, Osaka 571 (JP); Komatsu, Mikio, Matsushita Elec. Works Ltd., Kadoma-shi, Osaka 571 (JP); Ao, Naoki, Matsushita Elec. Works Ltd., Kadoma-shi, Osaka 571 (JP); Masamoto, Kyoji, Matsushita Elec. Works Ltd., Kadoma-shi, Osaka 571 (JP); Kimura, Yoshitaka, Matsushita Elec. Works Ltd., Kadoma-shi, Osaka 571 (JP)
(74) Representative: Kupecz, Arpad

(56) References cited:
- EP-A- 0 252 269
- EP-A- 0 325 701
- EP-A- 0 348 370
- EP-A- 0 350 323
- DE-A- 3 526 046
- FR-A- 2 518 822
- GB-A- 2 223 900
- US-A- 5 005 023
- PATENT ABSTRACTS OF JAPAN vol. 16, no. 178 (E-1196)28 April 1992

## Description

### BACKGROUND OF THE INVENTION

This invention relates to a low-noise-block downconverter (which shall be referred to simply as "LNB" hereinafter) for use with flat antennas designed for receiving dual polarized electromagnetic waves employed in reception of satellitic broadcast waves or for satellite communication and, more particularly, to an LNB which can execute frequency conversion of received signals of two different polarized electromagnetic waves and can alternatively provide as an output either one of the received signals.

### DESCRIPTION OF RELATED ART

In the satellitic broadcast wave reception or the satellite communication, generally, there has been employed a communication method for transmitting different sorts of information with different polarized electromagnetic waves used in respect of waves of the same frequency for the purpose of effective utilization of the frequency. In the case of, for example, circularly polarized electromagnetic waves, it is possible to transmit the different sorts of information with left handed polarized electromagnetic wave and right handed polarized electromagnetic wave or, in the case of linearly polarized electromagnetic waves, the transmission of the different sorts of information can be made with horizontally polarized electromagentic wave and vertically polarized electromagnetic wave. Here, it becomes necessary for receiving the two different polarized electromagnetic waves to render a receiving system to be of a simultaneous-dual type with two of single polarized electromagnetic wave receiving LNB employed, or to be of a switchable-dual type with a polarizer means additionally provided to the single polarized electromagnetic wave receiving LNB.

However, there has arisen a problem that the concurrent use of the two single polarized electromagnetic wave receiving LNB or the provision of the polarizer means with respect to the single polarized electromagnetic wave receiving LNB has rendered external formation of the LNB to be excessively larger and entire weight of the device to be also larger, and this problem has been particularly remarkable in the event when the LNB is applied to the flat antenna, in the latter of which the compactness, thinness and lightness have been keen demands.

In the dual polarized electromagnetic wave receiving LNB, further, the frequency conversion is executed preferably with a locally oscillated signal from a local oscillator utilized for lowering the frequency of the received signals, and the received signals subjected to the frequency conversion for the respective polarized electromagnetic waves are alternatively provided as the output. In this arrangement of employing the local oscillator for the frequency conversion, on the other hand, it is not avoidable that the locally oscillated signals from the local oscillator are caused to partly leak to input side and to output side as well. Taking into account any external influence thereof, such partial leakage of the locally oscillated signals should preferably be reduced as much as possible, and the leakage signal to the input side in particular is required to be sufficiently restrained since such signal is caused to be radiated through the antenna.

Generally, in the dual polarized electromagnetic wave receiving LNB of the type referred to, there are employed microstrip lines in interior circuit, and it is known that the locally oscillated signals are leaking through the microstrip lines to the input side and also as propagated through interior space of the LNB. In the interior circuit, therefore, metal plates are provided between respective constituent elements as partitions for dividing interior space into a plurality of regions mutually separated so as to restrain the spatial propagation of the locally oscillated signals. In an event where respective means for processing the polarized wave signals received include a radio frequency amplifier, it has been clarified that there arises a variation in the signal transmission characteristics between occasions where each of the radio frequency amplifiers operates and does not operate to alternatively provide the output, and there is still remained the problem that the received signals are caused to partly leak to the input side.

There have been disclosed converters to which the two different polarized electromagnetic waves are input, in Japanese Utility Model Laid-Open Publication No. 62-181007 of R. Sato, Japanese Utility Model Laid-Open Publication No. 1-133801 of K. Kajita, British Patent Application Nos. 88 16273.0 and 89 01278.5 of S.J. Flin et al, British Patent Application No. 88 16276.3 of K.R. Haward, Japanese Utility Model Laid-Open Publication No. 3-36243 of R. Koiso, and Japanese Patent Laid-Open Publication No. 3-228401. In any one of these prior art references, however, there has been disclosed no converter which satisfies the demands of the compactness, thinness and lightness.

EP-A3-0 348 370, which relates to a low-noise-block downconverter of the kind described in the precharacterizing part of appended claim 1, discloses an arrangement in which a downconverter is incorporated within a flat plate antenna. The downconverter occupies a certain amount of space within the antenna. Within the antenna dimensions therefore the space remaining for the other antenna parts is reduced, which may cause a deterioration in the antenna gain as well in antenna directivity.

### SUMMARY OF THE INVENTION

Accordingly, it is an object of the present invention to provide a low-noise-block downconverter for use with the flat antenna receiving dual polarized electromagnetic waves, which is made compact, thin and light and is capable of effectively preventing any signal leakage upon frequency conversion of the received signals.

According to the present invention, this object can be realized by means of a low-noise-block downconverter for use with a flat antenna receiving dual polarized electromagnetic waves, wherein the downconverter comprises a pair of feeding probes for receiving respectively each of two different output polarized electromagnetic wave signals through wave guide apertures of the flat antenna, the signals resulting from the dual polarized electromagnetic waves transmitted from an artificial satellite, and a selective means for receiving the signals from the feeding probes and a frequency converting means following said selective means, one of the polarized electromagnetic wave signals being alternatively selected at the selective means and subjected to a frequency conversion at a frequency converting means, characterized in that the downconverter is housed in a body case prepared separately from the flat antenna and mounted to a reverse side surface of the flat antenna, said body case having two input parts respectively corresponding to each of the wave guide apertures of the flat antenna and carrying each of the feeding probes in each of the input parts.

EP-A3-0 348 370 discloses a low-noise-block downconverter in a dual polarized version. That is, two LNB receivers are shown for use in combination with a flat antenna for receiving dual polarized electromagnetic waves. According to this prior art, however, the LNB receivers are provided on a ceramic or glass substrate respectively and are incorporated in each of two assemblies of a PDN (power divider network) layer and a radiating element layer respectively, which arrangement is entirely different from that of the present invention in which the downconverter is housed in a body case which is mounted to a reverse side of a flat antenna and is operatively coupled to the antenna through two wave guide apertures carrying the feeding probes disposed within the wave guide apertures. Further, the arrangement of the prior art has the disadvantage that the PDN and the radiating elements must be inherently reduced in number, due to the incorporation of the LNB and the ceramic or glass substrate into each of the layer assemblies of the antenna. Such a reduction in the number of constituent elements in a flat antenna results in reduction of the antenna gain, fluctuation in the directivity and so on. The present invention overcomes these shortcomings of the prior art.

Other objects and advantages of the present invention shall become clear as the description of the invention advances as detailed with reference to embodiments of the invention shown in accompanying drawings.

### BRIEF DESCRIPTION OF THE DRAWINGS

FIGURE 1 is a vertically sectioned view in an embodiment of the LNB for use with the flat antenna receiving dual polarized electromagnetic waves according to the present invention;
FIG. 2 is a rear side view of the LNB of FIG. 1;
FIG. 3 is an explanatory rear-side plan view of the flat antenna with which the LNB of FIG. 1 is used;
FIG. 4 is a block diagram of a circuit employed in the LNB of FIG. 1;
FIG. 5 is a vertically sectioned view in another embodiment of the LNB according to the present invention;
FIG. 6 is a rear side view of the LNB of FIG. 5;
FIG. 7 shown in a plan view of another embodiment of the LNB according to the present invention;
FIG. 8 is a fragmentary sectioned view as magnified of the LNB of FIG. 7;
FIG. 9 is a diagram showing operational characteristics of the LNB of FIG. 7;
FIG. 10 is a block diagram of a circuit employed in the LNB of FIG. 7;
FIG. 11 shows in a plan view another embodiment of the LNB according to the present invention;
FIGS. 12a and 12b are magnified views of an adjusting screw employed in the LNB of FIG. 11;
FIG. 13 is an explanatory view for the operation of the LNB of FIG. 11;
FIG. 14 is a block diagram of a circuit employed in another embodiment of the LNB according to the present invention;
FIG. 15 is a detailed circuit diagram at a main part of the circuit shown in FIG. 14;
FIG. 16 shows in a fragmentary plan view another embodiment of the LNB according to the present invention;
FIG. 17 is a fragmentary side view of the LNB of FIG. 16;
FIG. 18 shows in a perspective view a member employed in the LNB of FIG. 16;
FIG. 19 is a block diagram of a circuit employed in another embodiment of the LNB according to the present invention;
FIG. 20 shows in a plan view a working aspect of circuit pattern employed in the LNB of FIG. 19; and
FIG. 21 is a diagram showing the operational characteristics of the LNB in FIG. 19 in comparison with those of a prior art.

While the present invention shall now be described in the followings as detailed with reference to the respective embodiments shown in the drawings, it will be appreciated that the intention is not to limit the invention only to these embodiments shown but rather to include all alterations, modifications and equivalent arrangements possible with the scope of appended claims.

### DETAILED DESCRIPTION OF THE PREFERRED EMBODIMENTS

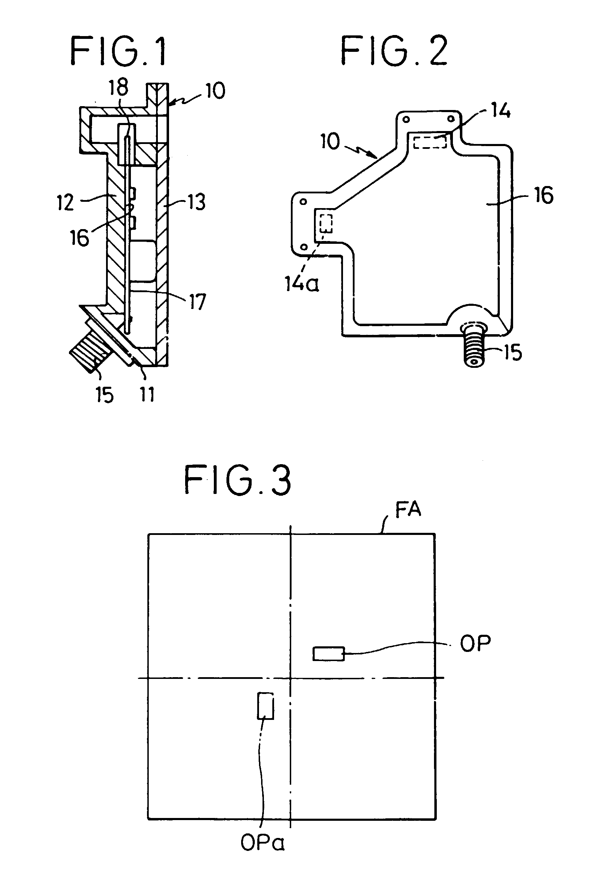

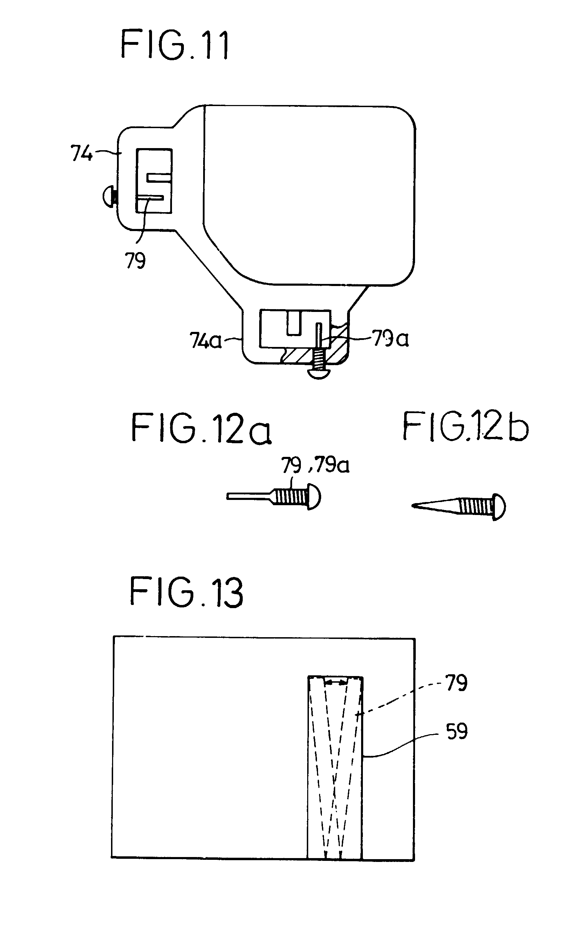

Referring to FIGS. 1 and 2, there is shown an LNB 10 for use with the flat antenna receiving the dual polarized electromagnetic waves, according to the present invention, which comprises a case body 11 formed to be generally flat, while this case body 11 is formed with, for example, a casing 12 opened on one side and a bottom plate 13 fitted to the open side of the casing 12. The case body 11 is provided for mounting to a rear side surface of such flat antenna FA as schematically shown in FIG. 13 so that input parts 14 and 14a opened on the side of the bottom plate 13 will be coupled to wave guide apertures OP and OPa formed in the rear side of the flat antenna FA for leading received polarized electromagnetic waves from the antenna FA into the LNB 10. The case body 11 is provided substantially on opposite side to one input part 14 with an output connector 15 projected for direct connection of a coaxial cable (not shown) to be connected to an associated receiver. On inner side of a top plate 16 of the casing 12 in the case body 11, a print-circuit board 17 carrying a circuit effectively employed according to the present invention is secured. To the print-circuit board 17, in addition, there are provided feeding probes 18 to be disposed respectively in each of the input parts 14 and 14a, while only one of such probes 18 is shown in the drawings.

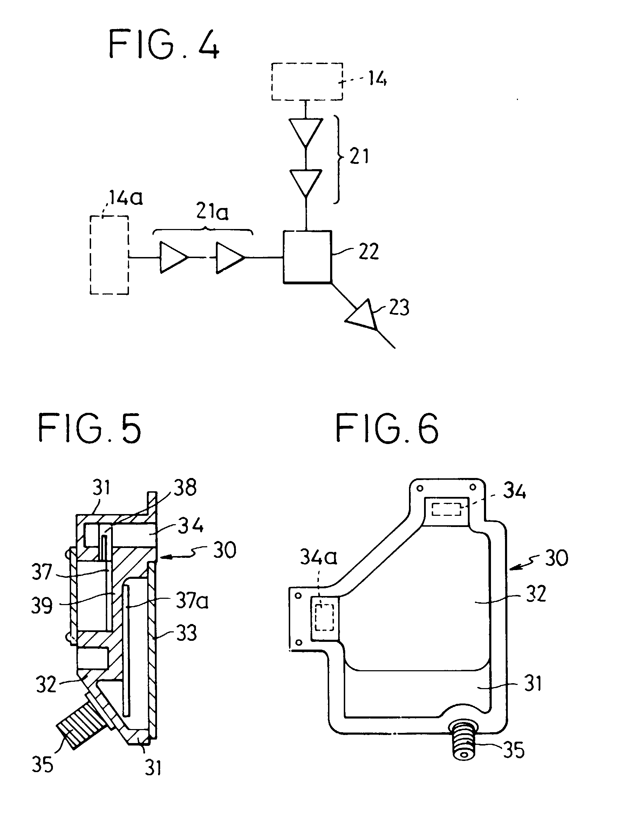

For the LNB according to the present invention, further, such circuit as shown in FIG. 4 preferably can be employed optimumly. More specifically, the polarized electromagnetic wave signals led in respectively from the input parts 14 and 14a through amplifiers 21 and 21a formed by such radio frequency transistors as a high electron mobility transistor (which shall be simply referred to as "HEMT" hereinafter) or the like are subjected properly to a selection at a selective means 22 allowing alternatively one of the two different polarized electromagnetic waves to pass therethrough, and the polarized electromagnetic wave passed through the selective means 22 is caused to be provided, through an amplifier 23 and a circuit (not shown) connected to a next stage thereof, to the output connector 15 for being transmitted through the coaxial cable eventually to the receiver.

It will be appreciated here that, according to the foregoing LNB of FIGS. 1 and 2, alternative one of the two different polarized electromagnetic waves can be propagated to the receiver without requiring a concurrent provision of another LNB or any addition of remarkable size arrangement, sufficiently realizing in particular the compactness, thinness and lightness.

In another embodiment shown in FIGS. 5 and 6 of the present invention, the print-circuit board is divided into a radio frequency part 37 and a remaining part 37a, which parts 37 and 37a are disposed on both side surfaces of a partition 39 spread in the case body 31 and to partly overlap each other as seen in plan view, whereby the LNB can be made to realize the compactness in the horizontal direction without substantially altering the thickness of the case body 31. In this embodiment of FIGS. 5 and 6, the same constituent members as those in the foregoing embodiment of FIGS. 1 and 2 are denoted by the same reference numerals as those used in FIGS. 1 and 2 but with an addition of "20", and the function of the device is also the same except for the above respect.

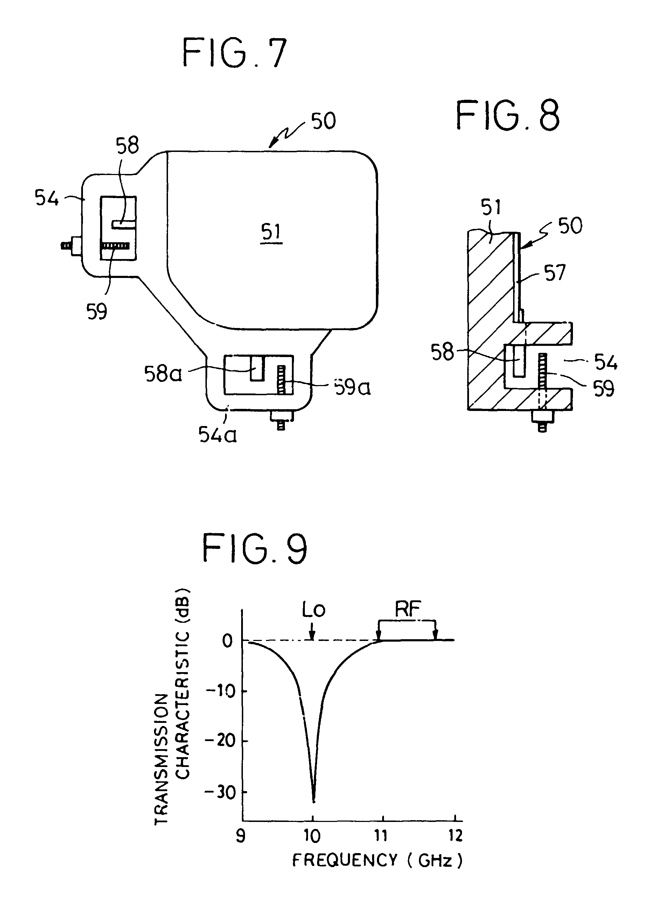

Referring next to another embodiment shown in FIGS. 7 and 8, the LNB 50 of this embodiment comprises a flat case body 51 which has two input parts 54 and 54a disposed substantially at right angled relationship to each other, and these input parts 54 and 54a are provided, as will be clear from FIG. 8, in the form of a recess opened on front side to be in match with the respective wave guide apertures in the rear side of the flat antenna FA. In these input parts 54 and 54a, the power supplying probes 58 and 58a extended from the print-circuit board 57 on front side of case body 51 are disposed to project, and adjusting screws 59 and 59a drivable forward and backward in the recesses 54 and 54a are mounted to the input parts.

In the foregoing arrangement, the adjusting screws 59 and 59a are provided to be parallel to a plane "E" and to be properly adjustable in their projection with respect to the input parts 54 and 54a along a plane "H", so that an optimum transmission characteristics can be obtained with the projection of the adjusting screws 59 and 59a into the recesses of the input parts 54 and 54a effectively adjusted.

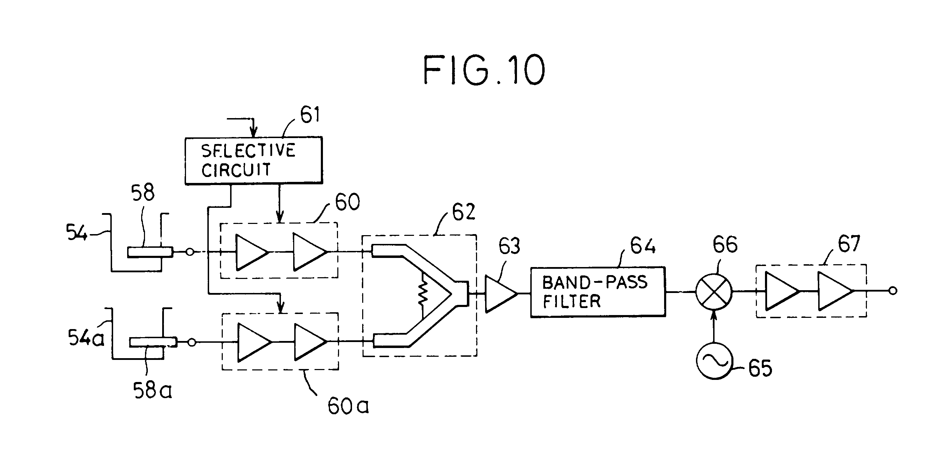

The polarized electromagnetic wave signals led into the input parts 54 and 54a are provided through the probes 58 and 58a to radio frequency amplifier circuit 60 and 60a, as shown in FIG. 10, but a power is supplied to alternative one of these radio frequency amplifier circuits 60 and 60a by means of the selective circuit 61, that is, only either one of the circuits 60 and 60a is to be operated. The polarized electromagnetic wave signal thus amplified by either one of the radio frequency amplifier circuits 60 and 60a is provided through a coupler 62 to another radio frequency amplifier circuit 63 to be thereby amplified and, then, to a band-pass filter 64 for rejecting image band frequency. At a frequency conversion means formed by a local oscillation circuit 65 and a mixer 66, the signal is mixed with a locally oscillated signal to be subjected to a predetermined frequency conversion, and the frequency converted signal is provided as an output after being amplified at an intermediate frequency amplifier circuit 67.

According to the above described embodiment of FIGS. 7 to 10, it is possible to attain further the compactness, thinness and lightness than in the case of the foregoing embodiment of FIGS. 1 to 4, and to adjust the transmission characteristics in accordance with the forward or backward projection of the adjusting screws 59 and 59a in respect of the input parts 54 and 54a, so that, once the center frequency of leakage preventing band is made to coincide with the locally oscillated signal Lo, only the locally oscillated signal Lo can be easily attenuated by about 30dB, without giving any substantial influence on the transmission characteristics of the received signal RF, as seen in FIG. 9. It is eventually possible to prevent the locally oscillated signal from partly leaking to the input side, and more remarkably to prevent the signal from being radiated through the antenna to the air.

In still another embodiment as shown in FIGS. 11 and 12a, the adjusting screws 79 and 79a mounted to the input parts 74 and 74a for the forward and rearward driving are made to be thinner at their projecting part into the recess than their threaded base part for the drivable mounting, so as to be about 1 to 1.5mm, for example, in the diameter. With this arrangement which is used generally with a resin applied to the whole of the adjusting screws 79 and 79a for their sealing and fixation, it is made possible to reduce required amount of the resin to be applied and also to reduce required driving extent of the screws for their easier mounting, since the thinner projecting part of each screw is rendering effective length of the threaded part to be shorter. In this case, the projecting parts of the screws may be tapered or made conical to be sharpened endwise, as shown in FIG. 12b. Further, even when the thinner projecting parts of the adjusting screws 79 and 79a are caused to rock or bent due to any external vibration or shock given after the adjusting driving of the screws 79 and 79a as shown by dotted lines in FIG. 13, the stroke of such rocking or bent will be substantially within an extent corresponding to the diametral extent of not thinned projecting part of the adjusting screw 59 employed in the embodiment of FIGS. 7-10 as shown by a solid line in FIG. 13, so that the variation in the transmission characteristics will be small and a stable operation can be expected in respect of the transmission. In the present embodiment, other constitution and function are substantially the same as those in the foregoing embodiment of FIGS. 7-10.

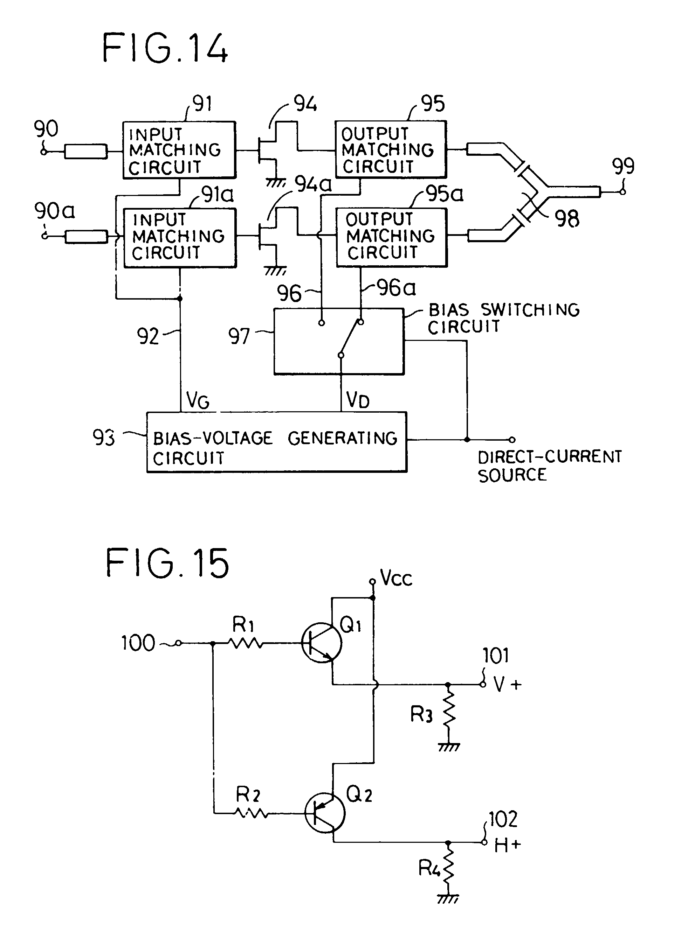

In another embodiment shown in FIG. 14, there is employed a further useful selective means. More specifically, there are connected to the input parts 90 and 90a such low noise amplifiers that respectively comprise each of input matching circuits 91 and 91a to which a voltage is constantly applied through a gate bias circuit 92 from a bias-voltage generating circuit 93, low noise FET's (Field Effect Transistors) or HEMT's 94 and 94a, and output matching circuits 95 and 95a to either one of which a bias voltage is applied from the bias-voltage generating circuit 93 through a bias switching circuit 97 and through either one of drain bias circuits 96 and 96a which is turned on by the circuit 97. An output from either one of the output matching circuits 95 and 95a is provided through a coupling circuit 98 to an output part 99.

In the foregoing bias switching circuit 97, as shown more in detail in FIG. 15, tehre is provided to an input end 100 a binary input of H level or L level, upon which, with a voltage of the H level, a transistor Q1 is actuated through a resistor R1 and a positive voltage is generated at an output terminal 101, while the other transistor Q2 is not actuated to generate no voltage at the other output terminal 102. With a voltage of the L level, on the other hand, the other transistor Q2 is actuated through a resistor R2, and a positive voltage is generated at the other output terminal 102, while the transistor Q1 is not actuated and no voltage is generated at the output terminal 101.

Thus, the polarized electromagnetic wave signal at either one of the input parts 90 and 90a only is amplified, and the output is provided out of the output part 99, upon which the gate bias constantly applied to the low noise FET's 94 and 94a can be effective to prevent these FET's from being electrically damaged.

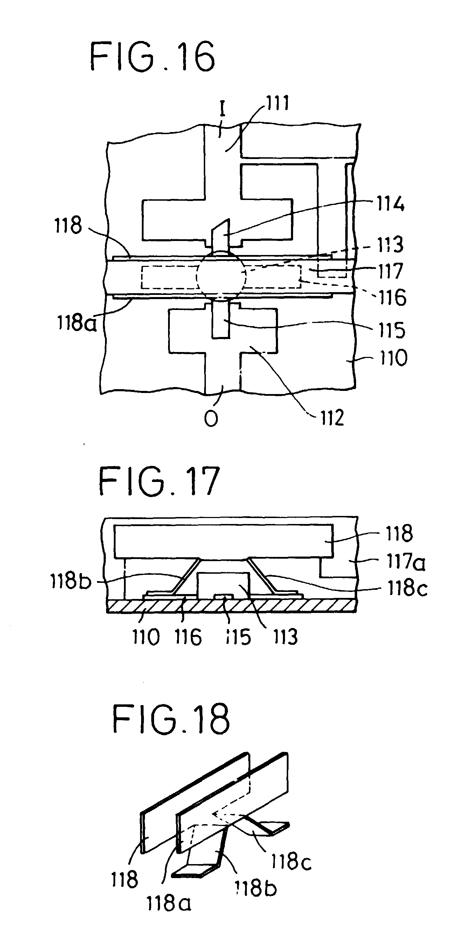

In another embodiment of the LNB according to the present invention, there is employed a circuit including such useful radio frequency amplifier as shown in FIGS. 16 to 18. In this radio frequency amplifier, a dielectric substrate 110 carries thereon a desired conductor pattern for forming a conductive land 111 having an input end I and a conductive land 112 having an output end O, and a grounding conductor land is formed between these input side and output side conductor lands 111 and 112. To the input side conductor land 111, in the present instance, an active element 113 comprising an HEMT is connected at its gate electrode 114 while, to the output side conductor land 112, the element 113 is connected at its drain electrode 115, and such source electrode 116 that constitutes a grounding electrode is connected to the grounding conductor land.

Further, a metal-made separator 117 is disposed above the active element 113, which separator 117 is preferably formed to be separated at its one leg part 117a from top surface of the dielectric substrate 110, so as to be kept in non-contacting state with respect to any one of the conductor lands. Further, this separator 117 is held between a pair of parallel holder plates 118 and 118a of a supporter, while these holder plates 118 and 118a are coupled to each other by a bridging part at central lower edges of them, the bridging part including a pair of resilient leg leaves 118b and 118c suspended diagonally downward in mutually opposite direction along longitudinal direction of the parallel holder plates 118 and 118a, and the leg leaves 118b and 118c are brought into resilient contact with the source electrode 116 forming the grounding electrode of the active element 113. In this case, the separator 117 is made to be grounded through the supporter and grounding electrode 116, so that any unnecessary oscillation can be prevented and the amplifier characteristics can be improved. Further, the separator 117 can be fixedly installed in simple manner by means of the holding plates 118 and 118a of the supporter, so that the amplifier can be also made excellent in the assembling ability.

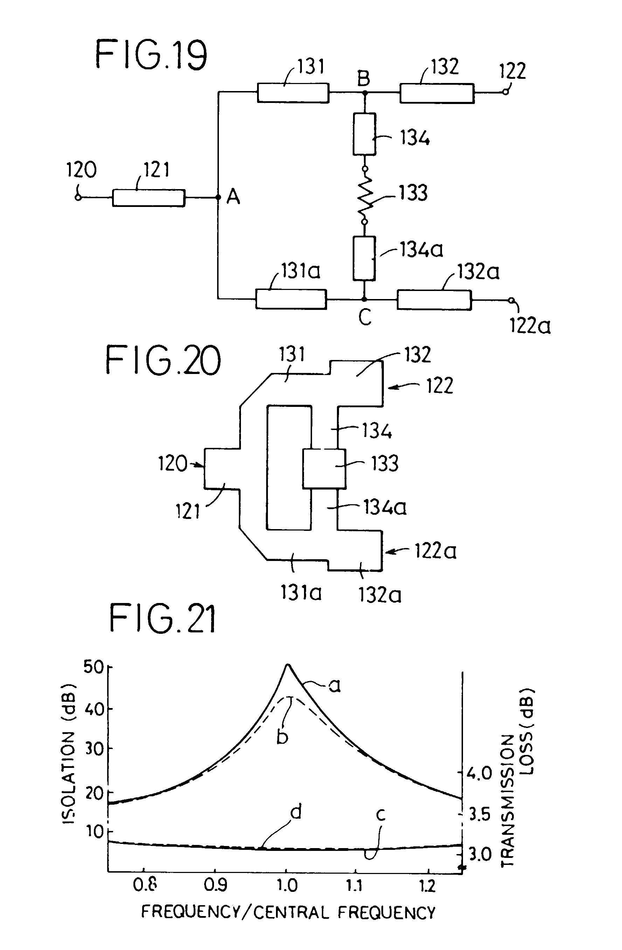

In still another embodiment of the LNB according to the present invention, there is employed a circuit including such useful coupler as shown in FIG. 19, which coupler comprises a pair of branch lines 131 and 131a made by microstrip lines formed on a dielectric substrate, preferably, the branch lines 131 and 131a being joined at their one ends and connected through a junction point A and an input line 121 to an input terminal 120 while connected at the other ends respectively through each of output lines 132 and 132a to output terminals 122 and 122a. Further, between both junction points B and C of the branch lines 131 and 131a and the output lines 132 and 132a, there is connected an absorbing resistor 133 through additional lines 134 and 134a. Here, in a path from the junction point B of one branch line 131 with one additional line 134 to the junction point C of the other branch line 131a with the other additional line 134a, a difference between a path through the branch line and a path through the additional line is set to be one half of a wavelength of the polarized electromagnetic wave signal propagated. It will be appreciated that, in the present embodiment, the branch lines are made longer by a length of the additional lines 134 and 134a.

In forming the foregoing coupler on the dielectric substrate by means of a print wiring, the same should be formed preferably in such a pattern as shown in FIG. 20, in which pattern the same portions as the circuit elements shown in FIG. 19 are denoted by the same reference numbers as those used in FIG. 19.

In FIG. 21, there are diagramatically shown variations in the isolation and transmission loss with respect to the frequency employed in the foregoing coupler. In the drawing, the ratio of the polarized electromagnetic wave frequency with respect to the central frequency is taken on the abscissa, solid line curves "a" and "c" denote the isolation and transmission loss in the case of the present embodiment, whereas dotted line curves "b" and "d" denote the isolation and transmission loss in the case of an aspect having no characteristic arrangement of the present embodiment. From these curves, it has been found that, for the transmission loss, the presence or absence of the characteristic arrangement of the present embodiment gives no remarkable influence, whereas, for the isolation, the present embodiment is successful in attaining an excellent outcome.

## Claims

1. A low-noise-block downconverter for use with a flat antenna receiving dual polarized electromagnetic waves, wherein the downconverter comprises a pair of feeding probes for receiving respectively each of two different output polarized electromagnetic wave signals through wave guide apertures of the flat antenna, the signals resulting from the dual polarized electromagnetic waves transmitted from an artificial satellite, and a selective means for receiving the signals from the feeding probes and a frequency converting means following said selective means, one of the polarized electromagnetic wave signals being alternatively selected at the selective means and subjected to a frequency conversion at a frequency converting means, **characterized** in that the downconverter is housed in a body case prepared separately from the flat antenna and mounted to a reverse side surface of the flat antenna, said body case having two input parts respectively corresponding to each of the wave guide apertures of the flat antenna and carrying each of the feeding probes in each of the input parts.

2. A downconverter according to claim 1, wherein said pair of input parts are disposed in mutually right angled relationship.

3. A downconverter according to claim 1, wherein said input parts include respectively an adjusting screw mounted thereto to be drivable forward and rearward for varying received-wave transmission characteristics.

4. A downconverter according to claim 3, wherein said adjusting screws are provided to be parallel to the E plane and adjustable in the projection into said input part along the H plane.

5. A downconverter according to claim 4, wherein said adjusting screws respectively have a projection side part made thinner than a mounting base part having screw threads.

6. A downconverter according to claim 1, wherein said selective means includes a pair of radio frequency amplifying means, a bias-voltage generating circuit constantly applying to said amplifying means a gate bias voltage, and a bias switching circuit which turns ON and OFF a drain bias only of the amplifying means in response to a drain bias voltage from said bias-voltage generating circuit so as to actuate selective one of the amplifying means.

7. A downconverter according to claim 1, which further comprises a radio frequency amplifier including an active element as a circuit element, and a separator disposed above said active element as held in position by a supporter which resiliently contacting with a grounding electrode for grounding said separator.

8. A downconverter according to claim 1, which further comprises a coupler as a circuit, said coupler including a pair of branch lines connected to an input terminal of said coupler, a pair of output lines connected respectively at one end to each of said branch lines and at the other end to each of a pair of output terminals of the coupler, and an absorbing resistor connected between both junction points between each of said pair of branch lines and each of said pair of output lines through additional lines, wherein a difference between a path through said branch line and a path through said additional line is set to be one half of a wavelength of said polarized electromagnetic wave signal propagated.

## Patentansprüche

1. Rauscharmer Abwärtskonverter zur Verwendung mit einer Flachantenne, die zweifach polarisierte elektromagnetische Wellen empfängt, wobei der Abwärtskonverter folgendes aufweist: ein Paar von Speisesonden, um jedes der zwei unterschiedlich polarisierten elektromagnetischen Ausgangs-Wellensignalen über die Wellenleiteröffnungen der Flachantenne zu empfangen, wobei die Signale von den zweifach polarisierten elektromagnetischen Wellen stammen, die von einem künstlichen Satelliten übertragen werden, und ein Selektionsmittel, um die Signale von den Speisesonden zu empfangen, und ein Frequenzumwandlungsmittel, das auf das Selektionsmittel folgt, wobei eines der polarisierten elektromagnetischen Wellensignale abwechselnd an dem Selektionsmittel ausgewählt und an einem Frequenzumwandlungsmittel einer Frequenzumwandlung unterzogen wird, dadurch gekennzeichnet, daß der Abwärtskonverter in einem Gehäuse eingeschlossen ist, das getrennt von der Flachantenne hergestellt und auf der Rückseite der Flachantenne montiert ist, wobei das Gehäuse zwei Eingangselemente aufweist, die jeweils den Wellenleiteröffnungen der Flachantenne entsprechen und jeweils die Speisesonden in jedem der Eingangselemente tragen.

2. Abwärtskonverter nach Anspruch 1, wobei das Paar von Eingangselementen im rechten Winkel zueinander liegt.

3. Abwärtskonverter nach Anspruch 1, wobei die Eingangselemente jeweils eine daran montierte Stellschraube aufweisen, um zur Änderung der Empfangswellen-Übertragungsmerkmale vorwärts und rückwärts beweglich zu sein.

4. Abwärtskonverter nach Anspruch 3, wobei die Stellschrauben parallel zu der Ebene E vorgesehen sind und der in das Eingangselement hineinragende Teil entlang der Ebene H verstellbar ist.

5. Abwärtskonverter nach Anspruch 4, wobei die Stellschrauben jeweils einen hineinragenden Seitenteil aufweisen, der dünner ausgebildet ist als ein Montage-Basisteil mit Schraubgewinde.

6. Abwärtskonverter nach Anspruch 1, wobei das Selektionsmittel folgendes enthält: ein Paar von Radiofrequenz-Verstärkungsmitteln, einen Vorspannungsgeneratorkreis, der eine Gattervorspannung konstant an das Verstärkungsmittel anlegt, und einen Vorschaltkreis, der nur für das Verstärkungsmittel eine Drain-Vorspannung als Reaktion auf eine Drain-Vorspannung aus dem Vorspannungsgeneratorkreis EIN und AUS schaltet, so daß selektiv eines der Verstärkungsmittel betätigt wird.

7. Abwärtskonverter nach Anspruch 1, der außerdem einen Radiofrequenzverstärker enthält, der ein aktives Element als Schaltkreiselement und einen Separator, der über dem aktiven Element liegt und durch einen Träger, der mit einer Erdelektrode zur Erdung des Separators elastisch in Kontakt ist, in Position gehalten wird, aufweist.

8. Abwärtskonverter nach Anspruch 1, der außerdem folgendes enthält: einen Koppler als Schaltkreis aufweist, wobei der Koppler ein Paar von Abzweigleitungen, die an ein Eingangsendgerät des Kopplers angeschlossen sind, ein Paar von Ausgangsleitungen, die jeweils an ein Ende von jeder der Abzweigleitungen und an das andere Ende von jeweils einem Paar von Ausgangsendgeräten des Kopplers angeschlossen sind, und einen absorbierenden Resistor, der zwischen beiden Anschlußpunkten zwischen jeder des Paares von Abzweigleitungen und jeder des Paares von Ausgangsleitungen über zusätzliche Leitungen angeschlossen ist, wobei ein Unterschied zwischen einem Weg über die Abzweigleitung und einem Weg über die zusätzliche Leitung so eingestellt ist, daß er halb so groß ist wie eine Wellenlänge des ausgebreiteten polarisierten elektromagnetischen Wellensignals.

## Revendications

1. Changeur de fréquence en bloc à faible bruit destiné à être utilisé avec une antenne plane recevant des ondes électromagnétiques à polarisation double, dans lequel le changeur de fréquence comprend une paire de tiges d'alimentation pour recevoir respectivement, par l'intermédiaire d'ouvertures de guidage de l'antenne plane, chacun de deux signaux différents à onde électromagnétique polarisée, les signaux résultant des ondes électromagnétiques à polarisation double émises depuis un satellite artificiel, et des moyens de sélection pour recevoir les signaux depuis les tiges d'alimentation, et des moyens de changement de fréquence après lesdits moyens de sélection, l'un des signaux d'onde électromagnétique polarisée étant sélectionné alternativement dans les moyens de sélection et soumis à un changement de fréquence dans les moyens de changement de fréquence,
caractérisé en ce que le changeur de fréquence est logé dans un boîtier de corps préparé séparément de l'antenne plane et monté sur une surface latérale arrière de l'antenne plane, ledit boîtier de corps ayant deux parties d'entrée correspondant respectivement à chacune des deux ouvertures de guide d'onde de l'antenne plane et portant chacune des tiges d'alimentation dans chacune des parties d'entrée.

2. Changeur de fréquence selon la revendication 1, dans lequel ladite paire de parties d'entrée sont disposées à angle droit l'une de l'autre.

3. Changeur de fréquence selon la revendication 1, dans lequel lesdites parties d'entrée comprennent respectivement une vis de réglage montée sur elles de manière à pouvoir être entraînée en avant et en arrière pour faire varier des caractéristiques de transmission d'onde reçue.

4. Changeur de fréquence selon la revendication 3, dans lequel lesdites vis de réglage sont disposées parallèlement au plan E et sont réglables en saillie pour pénétrer dans ladite partie d'entrée le long du plan H.

5. Changeur de fréquence selon la revendication 4, dans lequel lesdites vis de réglage ont respectivement une partie du côté de la saillie qui est rendue plus mince qu'une partie de montage de base ayant un filetage.

6. Changeur de fréquence selon la revendication 1, dans lequel lesdits moyens de sélection comprennent une paire de moyens d'amplification à haute fréquence, un circuit de génération de tension de polarisation appliquant constamment auxdits moyens d'amplification une tension de polarisation de grille, et un circuit de commutation de polarisation qui active ou désactive une polarisation de drain des moyens d'amplification seulement en réponse à une tension de polarisation de drain provenant dudit circuit de génération de tension de polarisation de manière à activer sélectivement l'un des moyens d'amplification.

7. Changeur de fréquence selon la revendication 1, qui comprend en outre un amplificateur à haute fréquence comprenant un élément actif comme élément de circuit, et un séparateur disposé au-dessus dudit élément actif et maintenu en position par un support qui entre en contact élastique avec une électrode de mise à la masse pour mettre à la masse ledit séparateur.

8. Changeur de fréquence selon la revendication 1, qui comprend en outre un coupleur comme circuit, ledit coupleur comprenant une paire de lignes de dérivation reliées à une borne d'entrée dudit coupleur, une paire de lignes de sortie reliées respectivement, à une extrémité, à chacune desdites lignes de dérivation, et, à l'autre extrémité, à chacune d'une paire de bornes de sortie du coupleur, et une résistance d'absorption branchée entre les deux points de jonction entre chacune de ladite paire de lignes de dérivation, et, par l'intermédiaire de lignes supplémentaires, chacune de ladite paire de lignes de sortie, dans lequel une différence entre un trajet dans ladite ligne de dérivation et un trajet dans ladite ligne supplémentaire est fixée égale à la moitié d'une longueur d'onde dudit signal diffusé d'onde électromagnétique polarisée.
